Europäisches Patentamt

European Patent Office

Office européen des brevets

(11) Veröffentlichungsnummer: **0 431 420 A2**

# (12) EUROPÄISCHE PATENTANMELDUNG

(21) Anmeldenummer: **90122424.6**

(22) Anmeldetag: **23.11.90**

(51) Int. Cl.5: **H01L 25/11**

(30) Priorität: **08.12.89 DE 3940637**

(43) Veröffentlichungstag der Anmeldung:
**12.06.91 Patentblatt 91/24**

(84) Benannte Vertragsstaaten:
**CH DE FR LI SE**

(71) Anmelder: **Siemens Aktiengesellschaft**
**Wittelsbacherplatz 2**
**W-8000 München 2(DE)**

(72) Erfinder: **Bardahl, Nils, Dr.**
**Albert-Schweitzer-Strasse 15**
**W-8521 Uttenreuth(DE)**

(54) **Hochstromgleichrichter.**

(57) Zur Verbesserung der Stromaufteilung werden bei einem Hochstromgleichrichter die Halbleiterventile (D) vorzugweise radial um die Wechselstromzuleitung (W) und die Gleichstromableitung (G) angeordnet. Die Wechselstromzuleitung (W) oder die Gleichstromableitung (G) ist dabei über einen bestimmten Bereich mantelförmig um jeweils andere Stromleitung angeordnet. Durch diese mantelförmige Anordnung der Stromleiter (G,W) ergibt sich für jeden Stromzweig des Hochstromgleichrichters ein annähernd gleicher Stromweg und gleiche Kommutierungsinduktivitäten.

FIG 1

EP 0 431 420 A2

## HOCHSTROMGLEICHRICHTER

Beim konstruktiven Aufbau von Hochstromgleichrichtern muß besonders auf eine gleichmäßige Stromverteilung geachtet werden. Eine ungünstige Stromverteilung führt nämlich dazu, daß der Stromrichter bzw. die Halbleiterventile nicht gleichmäßig ausgenutzt werden können und es so zu einer örtlich unterschiedlichen Erwärmung mit teilweiser Überbeanspruchung einzelner Halbleiterventile kommt. Werden die Halbleiterventile in üblicher Weise an einer Schiene aufgereiht, so kann die Stromverteilung entlang der Schiene bis zu $\pm$ 40 % je nach Länge der Schiene betragen.

Zur Verbesserung der stromverteilung wurden bisher auch radförmige Gleichrichteranordnungen gebaut. Bei diesen "Rad"-Gleichrichtern ist beispielsweise die Wechselstromzuleitung als "Nabe" ausgebildet und speichenförmig mit einer "Felge" verbunden. Die Felge kann kreisförmig oder auch vieleckig, beispielsweise sechseckig, ausgebildet sein. Die Halbleiterventile sind dabei an der Felge angebracht und stellen das Bindeglied zwischen den Speichen und der Felge dar, so daß der Strom über die Nabe, die Speichen und die Halbleiterventile zur Felge hin gleichgerichtet wird. An der Felge wird dann mit einer tangential angebrachten Sammelschiene der Gleichstrom abgeführt.

Aber auch eine solche Anordnung bringt noch Abweichungen in der stromverteilung von $\pm$ 20 bis $\pm$ 25 %, da der gleichgerichtete Strom von den der Sammelschiene gegenüberliegenden Halbleiterventilen einen weitaus größeren Weg zur Sammelschiene zurückzulegen hat als der von den Halbleiterventilen, die sich näher an der Sammelschiene befinden.

Aufgabe der Erfindung ist es die Stromverteilung von "Rad"-Gleichrichtern zu verbessern.

Diese Aufgabe wird durch eine Anordnung von Halbleiterventilen für einen Hochstromgleichrichter mit folgenden Merkmalen gelöst:

a) Die Halbleiterventile sind radial um die Wechselstromzuleitung und die Gleichstromableitung angeordnet,

b) die Wechselstromzuleitung oder die Gleichstromableitung ist über einen bestimmten Bereich mantelförmig um die jeweils andere Stromleitung angeordnet,

c) die Halbleiterventile sind mit der Anode oder der Kathode auf einem Kühlkörper befestigt, der mit der Wechselstromzuleitung oder der Gleichstromableitung über Zuleitungen elektrisch leitend verbunden ist,

d) die Kathode oder die Anode der Halbleiterventile ist mit der Gleichstromableitung oder der Wechselstromzuleitung ebenfalls über Zuleitungen elektrisch leitend verbunden.

Für die mantelförmig angeordneten Stromzu- und ableitungen ist eine koaxiale Anordnung wegen der symmetrischen elektrischen Felder besonders vorteilhaft. Da sich beide Stromleiter sozusagen als Nabenkonstruktion in der Mitte des "Rad"-Gleichrichters befinden, ergibt sich für alle Halbleiterventilanordnungen nahezu der gleiche Stromweg und gleiche Kommutierungsinduktivitäten. Werden die Kühlkörper noch dazu in Form eines Vielecks, insbesondere eines Sechsecks angeordnet, wobei die Wechselstromzuleitung und die Gleichstromableitung den Mittelpunkt des Vielecks bilden, dann lassen sich die Halbleiterventile einfach an den Kühlkörpern anbringen und mit der koaxialen Stromzu- und ableitung verbinden. Außerdem können die dann flächenmäßig ausgebildeten Kühlkörper in einfacher Weise mit Kühlvorrichtungen wie Lamellen oder Kühlblechen versehen werden.

Der Kühlkörper kann aber auch als Kreisring ausgebildet sein, der über beispielsweise speichenförmige Zuleitungen mit der Wechselstromzuleitung oder der Gleichstromableitung verbunden ist. Welcher der Stromleiter der mantelförmigen oder koaxialen Anordnung als Wechselstromzuleitung oder Gleichstromableitung verwendet wird, kann im Einzelfall vom Fachmann entschieden werden. Die Querschnittsflächen des Innen- und Außenleiters können dabei den jeweiligen Leistungsbedürfnissen angepaßt werden.

Ein jeweiliges Halbleiterventil kann vorteilhaft mit einer Kühldose und einer Sicherung an mindestens einem Pol versehen sein. Die Kühldosen und andere zur Kühlung beitragende Elemente, beispielsweise die Kühlkörper, können dabei zusätzlich noch an einen Flüssigkeits-Kühlkreislauf angeschlossen sein.

Ein Ausführungsbeispiel der Erfindung ist in der Zeichnung dargestellt und wird im folgenden näher beschrieben. Dabei zeigen:

FIG 1      die Draufsicht auf einen sechseckig ausgebildeten koaxialen "Rad"-Gleichrichter,

FIG 2      eine Vorderansicht des sechseckigen "Rad"-Gleichrichters,

FIG 3      eine Anordnung mehrerer sechseckiger "Rad"-Gleichrichter für eine sechspulsige Gleichrichtung.

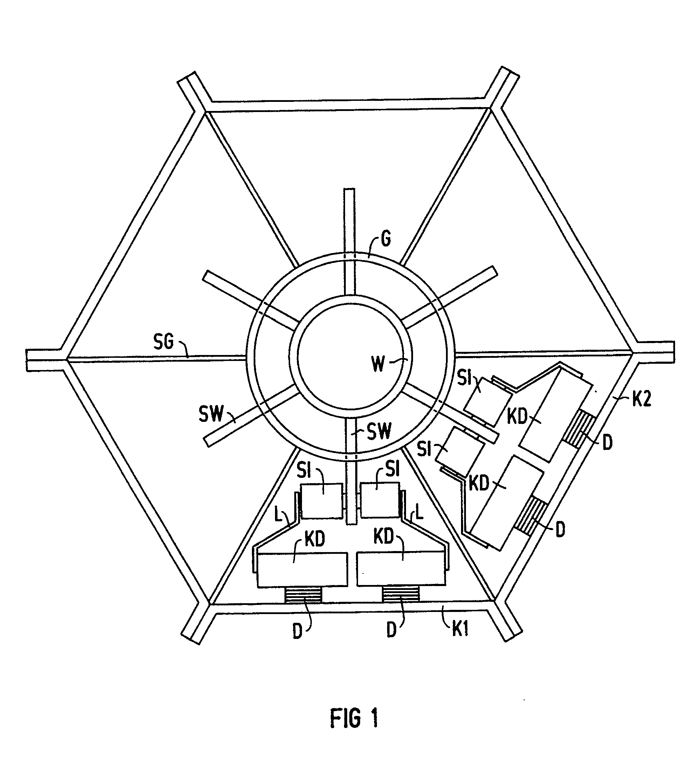

FIG 1 zeigt einen sechseckigen Hochstromgleichrichter mit koaxialer Wechselstromzuführung W und Gleichstromableitung G. Die Gleichstromzuleitung G ist dabei als Außenleiter der koaxialen Anordnung ausgebildet. Die Wechselstromzuleitung W ist als rohrförmiger Stromleiter beispielsweise in Form eines Aluminiumrohres ausgebildet. Der Stromleiter könnte aber auch stabförmig ausgebildet sein. Die Gleichstromableitung G ist über die speichenförmigen Zuleitungen SG mit den Ecken eines Sechseckes verbunden. Das Sechseck ist aus Kühlkörpern K1,K2 ... gebildet, die an ihren Enden miteinander verbunden sind. An der Innenseite der Kühlkörper K1,K2 sind jeweils die Halbleiterventile D angeordnet. Dabei können nicht nur wie in FIG 1 zu sehen, zwei Halbleiterventile D auf einem Kühlkörper K1, K2 angebracht werden, sondern je nach dem wie hoch der Kühlkörper K1, K2 ausgebildet ist, d.h. wie weit er sich in die Zeichenebene erstreckt, können mehrere der Halbleiterventile übereinander angebracht sein.

Die Halbleiterventile D können gesteuerte oder ungesteuerte Halbleiterventile sein. In FIG 1 sind sie als sogenannte Scheibendioden, oder Scheibenthyristoren ausgebildet. Es könnten aber beispielsweise auch sogenannte Schraubgleichrichter verwendet werden, die mit ihrem Schraubgewinde am Kühlkörper K1, K2 befestigt sein könnten.

Auf den Halbleiterventilen D sind Kühldosen KD angebracht, die Kühlkanäle aufweisen können, durch die eine Kühlflüssigkeit gepumpt wird. Diese Kühldosen KD können mittels isolierten Schraubbolzen mit dem Kühlkörper K1, K2 so verbunden werden, daß die dazwischenliegenden Halbleiterventile D unter Druck verspannt werden.

Die Kühldosen KD sind über winkelförmige Leiter L mit jeweils einem Pol von Sicherungen SI verbunden. Der andere Pol der Sicherungen SI ist mit vom Wechselstromzuleiter W wegführenden speichenförmigen Zuleitungen SW verbunden.

Durch die koaxialsymmetrische Anordnung ist nun ein weitestgehend gleichmäßiger Stromfluß von der Wechselstromzuleitung W über die Halbleiterventile D zur Gleichstromableitung G gewährleistet. Jeder Stromzweig zwischen der Wechselstromzuleitung W und der Gleichstromableitung G besteht damit im Beispiel der FIG 1 aus einer speichenförmigen Zuleitung SG, einem Teil eines Kühlkörpers K1, K2, einem Halbleiterventil D, einer Kühldose KD, einem abgewinkelten Stromleiter L, einer Sicherung SI und einer speichenförmigen Zuleitung SW. Die verbleibenden unterschiedlichen Stromwege, die sich ergeben, wenn der Gleichstrom beispielsweise tangential von der Gleichstromableitung G abgenommen wird, sind sehr viel kleiner als die unterschiedlichen Stromwege, die sich ergeben, wenn der Gleichstrom an der Peripherie, d.h. im Beispiel der FIG 1, an einem Kühlkörper K1, K2 abgenommen würden. Durch diese Anordnung ergeben sich für jeden Stromweg annähernd gleiche Induktivitäten und damit gleiche Kommutierungsflächen.

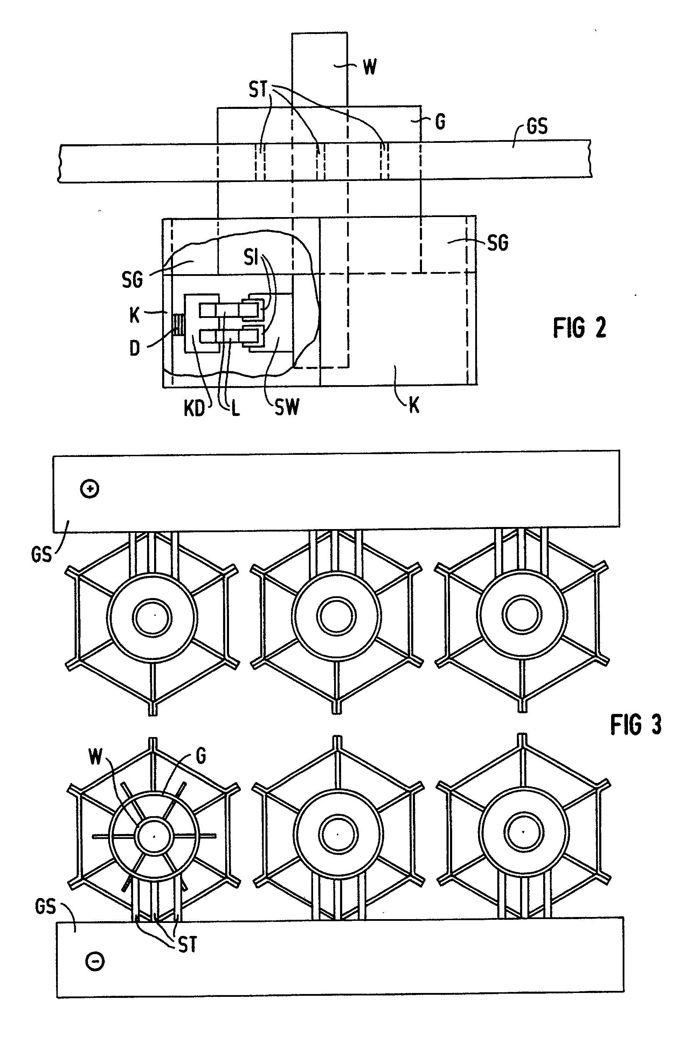

FIG 2 zeigt eine mögliche Vorderansicht eines Hochstromgleichrichters nach FIG 1. Dabei ist der rohrförmig ausgebildete Wechselstromzuleiter W zu sehen, der die koaxial um ihn angeordnete Gleichstromableitung G überragt, um den Wechselstromanschluß zu ermöglichen. Am Gleichstromableiter G ist eine Gleichstromsammelschiene mittels drei lamellenförmiger Stege ST angeschweißt. Die kreiszylindrische Gleichstromableitung G reicht nicht ganz bis in die Mitte der sechseckförmigen Anordnung aus den Kühlkörpern K hinein. Die Wechselstromzuleitung W reicht knapp bis zum unteren Ende der Kühlkörper K1, K2. In der aufgeschnittenen Darstellung ist im Inneren der Anordnung eine speichenförmige Zuleitung SW zu erkennen, die an der Wechselstromzuleitung W beispielsweise angeschweißt sein kann. An der Zuleitung SW sind zwei Sicherungen SI befestigt, die über zwei Leitungen L und eine Kühldose KD mit der Diode D verbunden sind. Die Diode D ist mit ihrem anderen Pol mit dem Kühlkörper K1, K2 verbunden.

FIG 3 zeigt eine Anordnung mit sechseckigen "Rad"-Gleichrichtern, wobei jeweils drei dieser Gleichrichter mit jeweils einer Gleichstromsammelschiene GS verbunden sind. Die Wechselstromzuführung W ist diesmal ebenfalls als Kreiszylinder ausgebildet. Die Gleichstromschienen GS sind jeweils über drei lamellenförmige Stege ST mit einer sechseckigen Gleichrichteranordnung verbunden. Die gesamte Anordnung kann dabei so angebracht werden, daß eine senkrecht zu der Anordnung vorgesehene Luftströmung ganz oder teilweise zur Kühlung beiträgt.

Die Gleichstromableitung G und/oder die Wechselstromzuleitung W müssen nicht notwendigerweise kreisförmigen Querschnitt aufweisen. Sie können einen beliebigen Querschnitt, beispielsweise wie die Kühlkörperanordnung einen vieleckigen Querschnitt aufweisen.

**Ansprüche**

1. Anordnung von Halbleiterventilen für einen Hochstromgleichrichter mit folgenden Merkmalen:

   a) Die Halbleiterventile (D) sind um die Wechselstromzuleitung (W) und die Gleichstromableitung (G) angeordnet,

   b) die Wechselstromzuleitung (W) oder die Gleichstromableitung (G) ist über einen bestimmten Bereich mantelförmig um die jeweils andere Stromleitung (G,W) angeordnet,

   c) die Halbleiterventile (D) sind mit der Anode oder der Kathode auf einem Kühlkörper (K1,K2) befestigt, der mit der Wechselstromzuleitung (W) oder der Gleichstromableitung (G) über Zuleitungen (SW,SG) elektrisch leitend verbunden ist,

   d) die Kathode oder die Anode der Halbleiterventile (D) ist mit der Gleichstromableitung (G) oder der Wechselstromzuleitung (W) ebenfalls über Zuleitungen (SG,SW) elektrisch leitend verbunden.

2. Hochstromgleichrichter nach Anspruch 1, **dadurch gekennzeichnet**, daß die Wechselstromzuleitung (W) und die Gleichstromableitung (G) koaxial aufgebaut sind.

3. Hochstromgleichrichter nach Anspruch 1 oder 2, **dadurch gekennzeichnet**, daß die Kühlkörper (K1,K2) vieleckig angeordnet sind.

4. Hochstromgleichrichter nach Anspruch 1 oder 2, **dadurch gekennzeichnet**, daß als Kühlkörper (K) ein Kreisring verwendet wird, der über die Zuleitungen (SW, SG) mit der Wechselstromzuleitung (W) oder der Gleichstromableitung (G) verbunden ist.

5. Hochstromgleichrichter nach einem der vorhergehenden Ansprüche, **dadurch gekennzeichnet**, daß ein jeweiliges Halbleiterventil (D) mit einer Kühldose (KD) und einer Sicherung (SI) an mindestens einem elektrischen Pol angeschlossen ist.

FIG 1

FIG 2

FIG 3